# EUROPEAN PATENT APPLICATION

(11) **EP 1 411 147 A1**
(43) Date of publication of application: **21.04.2004**
(21) Application number: 02257254.9
(22) Date of filing: 18.10.2002
(51) Int. Cl.: C23C 18/40

(54) **Formaldehyde-free electroless copper plating process and solution for use in the process**

(71) Applicant: Shipley Co. L.L.C., Marlborough, MA 01752 (US)
(72) Inventor: Seita, Masaru, Kitaadachi-gun, Saitama 362-0805 (JP); Tsuchida, Hideki, Hasuda-shi, Saitama 349-0127 (JP); Imanari, Masaaki, Misato-shi, Saitama 341-0026 (JP); Sugita, Yoshihiro, Kitaadachi-gun, Saitama 362-0805 (JP); Egli, Andre, 8712 Staefa (CH); Brasch, William R., Sarasota, Florida 34238 (US)
(74) Representative: Kent, Venetia Katherine

(57) **Abstract**

This invention provides a process for electroless copper plating without using formaldehyde and an electroless copper plating solution which is used in the process. To this end, there is disclosed a process for electroless copper plating, which treatment comprises depositing a palladium or palladium-tin catalyst on a resin substrate, and then treating said resin substrate having the catalyst deposited thereon with a formaldehyde-free electroless copper plating solution that contains copper ions and a reducing agent, wherein the need for an accelerating treatment of a catalyst after said catalyst depositing treatment is obviated. The productivity of a copper-resin composite material is dramatically enhanced by the process of the present invention, because a copper thin layer can be formed on the resin substrate in a short time, even if an accelerating treatment for a catalyst is not performed in a separate process.

## Description

### [Detailed Description of the Invention]

### [Technical Field of the Invention]

The present invention relates to a process for electroless copper plating using a formaldehyde-free electroless copper plating solution containing a copper ion and a reducing agent.
The present invention also relates to an electroless copper plating solution used for the above-mentioned process and a copper-resin composite material obtained by this process.

### [Background of the invention]

In preparing a printed circuit board, an electroless plating process utilizing an electroless copper plating solution is employed to provide a conductive copper layer in a through-hole of a non-conductive plastic substrate. On the conductive copper layer in the through hole, an electro copper plating is then applied.

### [Problems to be solved by the Invention]

A significant problem inherent in the method of the prior art is the use of formaldehyde in electroless copper plating solutions. Formaldehyde is implicated in teratogenecity, mutagenesis, and carcinogenesis. Thus, some formaldehyde-free electroless copper plating solutions have been developed.
Further, in an electroless copper plating process of the prior art utilizing an electroless plating solution including formaldehyde, a problem is encountered that, unless a catalyst is used, a time required for deposition of copper is long. Most conventional formaldehyde-free electroless copper plating solutions have poor stability due to their high reactivity, and rapidly decompose when used. It has therefore been desired to develop a formaldehyde-free electroless copper plating solution which is highly bath-stable, and use of which enables an electroless copper plating process to be completed rapidly.

An object of the present invention is to provide an electroless copper plating process which does not require the use of formaldehyde, thereby eliminating the environmental effects associated with use of the chemical. Formaldehyde is implicated in teratogenecity, mutagenesis, and carcinogenesis. A further object of the present invention is to provide a formaldehyde-free electroless copper plating solution which is capable of rapidly depositing copper; and, a still further object of the present invention is to provide a formaldehyde-free, rapidly reacting electroless copper plating solution which exhibits high bath stability.

### [Means to solve the Problems]

The present invention provides a formaldehyde-free process for electroless copper plating comprising the steps of:
1) depositing a palladium or palladium-tin catalyst on a resin substrate; and
2) treating the substrate with a formaldehyde-free electroless copper plating solution containing copper ions and a reducing agent.
   The present invention also relates to a formaldehyde-free electroless copper plating solution used in the claimed process, as well as a composite material prepared in accordance with the process.
   The present invention further relates to a process for electro copper plating on said composite material prepared in accordance with the process, as well as a composite material prepared in accordance with the process.

### [Preferred Embodiments]

In the present invention, "electroless copper plating" refers to a chemical process whereby a conductive copper layer is formed on a resin substrate. This deposition is carried out before a subsequent plating treatment, such as copper sulfate plating. In the present invention, a high-conductive copper thin layer is formed rapidly on a resin substrate having a palladium or palladium-tin catalyst provided on its surface. A formaldehyde-free aqueous electroless copper plating bath solution is provided in the present invention for use in the process. The bath solution comprises copper ions and a reducing agent, and is capable of forming a thin copper layer on a resin substrate which is provided on its surface with a palladium or palladium-tin catalyst, wherein the accelerating treatment for the catalyst has not been subjected. In the present invention, "electroless copper solution" refers to a bath solution capable of forming a thin copper layer on the substrate by contacting with the substrate, wherein the palladium or palladium-tin catalyst without an accelerating treatment exists on a surface of the substrate.
Use of such a catalyst on the substrate surface obviates the need for an accelerating treatment.

Copper ions to be present in the solution can be derived from any suitable source. For example, a copper compound that can generate copper ions when it is dissolved in the bath solution may be used. Alternatively, a compound can be dissolved in water to form a solution containing copper ions and then supplied to the bath solution. Copper compounds useful as copper sources include those which are water-soluble; contain copper ions; and which have been conventionally used in the art. Preferably, such compounds will include: copper sulfate; copper nitrate; copper chloride; copper hydroxide; copper sulfamate; cuprous carbonate; copper oxide, and the like. More preferably used are copper sulfate and copper chloride. Suitable copper compounds may be used either alone or in combination.
A concentration of copper ions in the solution is normally 0.5 to 5 g/L, and preferably 1to 2g/L, calculated as copper metal. However, when the electroless copper plating solution of the present invention includes a complexing agent and the concentration of the complexing agent is high, the concentration of copper ions may be 2g/L or more. For example, the concentration of copper ions may be as high as 10g/L or more.

Reducing agents used in the electroless copper plating solution of the present invention are those that are water soluble and capable of reducing copper ions to deposit metallic copper on a resin substrate. With the exception of formaldehyde, any reducing agent can be used. Examples of preferable reducing agents include, but are not limited to: sodium boron hydride; potassium boron hydride; dimethylamino borane; trimethylamino borane; hydrazine; and derivatives of these compounds. More preferable for use as a reducing agent are sodium boron hydride; potassium boron hydride; dimethylamino borane; trimethylamino borane; hydrazine; and derivatives of these compounds. Even more preferable for use as a reducing agent are sodium boron hydride and potassium boron hydride; and most preferable is sodium boron hydride. The reducing agents mentioned above may be used either alone or in combination.
The concentration of a reducing agent in the electroless copper plating solution of the present invention is normally 0.1 - 10g/L, and preferably 0.5 - 2g/L. At concentrations exceeding 10g/L, the bath-solution becomes unstable and the reducing agent tends to become exhausted.

Optionally, the electroless copper plating solution of the present invention may include a complexing agent. A complexing agent used must be capable of complexing copper ions. Examples include, but are not limited to: polyamine and a salt thereof; aminocalboxylic acid and a salt thereof; oxycarboxylic acid and a salt thereof; alkanolamine and a salt thereof; and the like. In the present invention, either a single complex agent or a combination of agents can be used.

Polyamines and salts thereof include, for example, ethylenediamine, diethylenetriamine, diethylenetetramine, triethylenetetramine and the like, as well as a hydrochloride, a sulfate and the like; but are not limited to these.
A polyamine and a salt thereof in the electroless copper plating solution is normally be used at a concentration of 1-100g/L, and preferably 5-50g/L.

Aminocarboxylic acids and their salts include, but are not limited to: iminodiacetic acid and a sodium salt thereof; nitrilotriacetic acid and a sodium salt thereof; and, hydroxyethylethylene diaminetriacetic acid; tetrahydroxyethylene diamineacetic acid; dihydroxymethylethylene diaminediacetic acid; ethylenediamine tetraacetic acid; cyclohexane-1,2-diaminetetraacetic acid; ethyleneglycoldiethylether diaminetetraacetic acid; ethylenediamine tetrapropionic acid; N,N,N',N'-tetrakis-(2-hydroxylpropyl) ethylenediamine, and the like, as well as a sodium salt thereof, and a potassium salt thereof.
These compounds will normally be used in the electroless copper plating solution at a concentration of 1-100 g/L, and preferably 5-50 g/L.

Alkanolamine compounds preferably include: mono-, di- and tri-ethanolamine, but are not limited to these. Alkanolamine compounds will normally be used in the electroless copper plating solution at a concentration of 5-200ml/L, and preferably 50-100g/L.
Examples of oxycarboxylic acids include: tartaric acid; citric acid; and gluconic acid. Examples of salts of oxycarboxylic acids include, sodium tartarate; potassium tartarate; sodium potassium tartarate; sodium citrate; potassium citrate; ammonium citrate; sodium gluconate; and potassium gluconate; but are not limited to these. Normally, the above-mentioned compounds will be used in the electroless copper plating solution of the present invention at a concentration of 1-100g/L, and preferably 5-50g/L.

The electroless copper plating solution of the present invention may optionally include: a water-soluble thallium compound; a water-soluble cerium compound; and/or a water-soluble sulfide. By including a water-soluble thallium compound, water-soluble cerium compound and/or the water-soluble sulfide in the electroless copper plating solution, the stability of the bath solution can be remarkably improved. Most preferable are a water-soluble thallium compound and/or a water-soluble cerium compound.
Any water-soluble thallium or cerium compounds can be used in the electroless copper plating solution of the present invention. As a water-soluble sulfide, there may be used any solution-soluble compound that includes an element of sulfur in the form of sulfide. The water-soluble thallium compounds, cerium compounds or sulfides can comprise a compound including any one of a cerium element, thallium element or sulfur element in the form of sulfide; or may comprise compounds including a plurality of elements of cerium, thallium, and sulfur in the form of sulfide. In addition, these compounds may be employed either singly or in combination.
Said water-soluble thallium compound, said water-soluble cerium compound and/or said water-soluble sulfide may be dissolved directly in the electroless copper plating solution or may be dissolved once in water; then the resultant solution may be added to the bath solution.

Water-soluble cerium compounds that can be used in the present invention include, for example, a salt such as cerium acetate; cerium nitrate; cerium sulfate; cerium bromide; cerium carbonate; cerium chloride; cerium fluoride; cerium oxalate and a hydrate thereof; but are not limited to these. Water-soluble thallium compounds that can be used in the present invention, include a salt such as thallium chloride; thallium formate; thallium nitrate; thallium oxide;thallium sulfate; and thallium acetate, or a hydrate thereof, but are not limited to these. Sulfides that can be used in the present invention include a sulfide of an alkali metal or an alkaline earth metal, but are not limited to these. Preferably, water-soluble sulfides include sodium sulfide; sodium hydrogen sulfide; potassium sulfide; potassium hydrogen sulfide; barium sulfide; barium hydrogen sulfide; magnesium sulfide; magnesium hydrogen sulfide; and the like. More preferably, water-soluble sulfides include sodium sulfide; sodium hydrogen sulfide; potassium sulfide and potassium hydrogen sulfide.
The amount of the water-soluble thallium compound, water-soluble cerium compound and/or the water-soluble sulfide that are included in the electroless copper plating solution may be sufficient to stabilize the electroless copper plating solution. The amount of the water-soluble cerium compound is normally 1mg/L-1000mg/L, preferably 5mg/L-30mg/L. The amount of the water-soluble thallium compound is normally 1mg/L-1000mg/L, preferably 5mg/L-30mg/L, and the amount of the water-soluble sulfide is normally 1mg/L-1000mg/L, preferably 5mg/L-20mg/L.

Optionally, the electroless copper plating solution of the present invention may include iodine and/or a water-soluble iodine compound. Preferably, the electroless copper plating solution of the present invention includes iodine and/or a water-soluble iodine compound. When iodine or a water-soluble iodine compound is included in the electroless copper plating solution, the stability of the electroless copper plating bath is improved and the deposition rate of copper is enhanced. The advantage obtained by including an iodine element in the electroless copper plating solution is that it increases both the stability of the electroless copper plating bath and the deposition rate of copper. This effect can be accomplished under normal conditions in the process of the present invention.
When iodine or a water-soluble iodine compound is included in the electroless copper plating solution, a further advantage is obtained whereby deposited copper becomes densified and the obtained copper layer has a glossy and metallic copper color tone. In the electroless copper plating process of the present invention, when the electroless copper plating solution does not contain an iodine ion, a deposited copper layer has a glossless as opposed to metallic appearance. In the electroless copper plating field, the appearance of the deposited copper layer is regarded as important, therefore, particularly a need for a copper layer having a glossy metallic surface appearance is desired.
Any compound including iodine in its molecule and being soluble in the electroless copper plating solution can be used as a water-soluble iodine compound in the present invention, but are not particularly limited to these. For the water-soluble iodine compound, iodine may be present in any form, for example, in the form of an iodine ion salt, such as potassium iodide, ammonium iodide, sodium iodide, thallium iodide; or in the form of covalent bound of iodine and an organic compound such as 1,3-dichloro-4-iodobenzene, 8-hydoroxy-7-iodo-5-quinolinesulfonic acid, and iodine benzoic acid. The water-soluble iodine compound that is included in the present invention may be used alone or may be used in combination therewith.
The water-soluble iodine compound may include simultaneously another ingredient useful in the present invention, such as thallium iodide.
Also iodine and/or said water-soluble iodine compound may be dissolved directly in the electroless copper plating solution or may be dissolved once in water, with the resultant solution then being added to the bath solution.

In the electroless copper plating solution of the present invention, an iodine element may be present in the form of iodine ions or in a part of the molecule, such as a compound wherein iodine is covalently bound to an organic compound mentioned above. Preferably, the electroless copper plating solution of the present invention includes an iodine compound.
It is conjectured that iodine accelerates the deposition reaction of copper during the electroless copper plating treatment, through a mechanism whereby iodine is adsorbed on a palladium catalyst or a palladium-tin catalyst that has not been subjected to an accelerating treatment. It is also conceivable that an iodine element itself acts on the palladium catalyst or the palladium-tin catalyst, since iodine has the aforementioned effects either in ion form or in a state where it is covalently bound to the compound.

Iodine and/or a water-soluble iodine compound that are included in the electroless copper plating solution of the present invention are unable to exhibit the effect of accelerating the deposition of copper when used in a too small an amount, and they cause the palladium catalyst or the palladium-tin catalyst to be inactive when used in excess amounts. Therefore, an amount of iodine and/or a water-soluble compound is normally 1mg/L-1000mg/L, preferably 5mg/L-30mg/L and more preferably 10mg/L-20mg/L, based on the weight of iodine.

Optionally, the electroless copper plating solution of the present invention may include hydantoin and/or a derivative of hydantoin. When hydantoin and/or a hydantoin derivative are included in the electroless copper plating solution, the deposition rate of copper is accelerated. Preferably, the electroless copper plating solution of the present invention includes a derivative of hydantoin.
As an embodiment of the present invention for the derivative of hydantoin contained in the electroless copper plating solution of the present invention, any compound having a hydantoin structure may be used. Another embodiment of the present invention includes those compounds that are obtained by cleavage of a hydantoin ring of the compound having hydantoin structure such as hydantoic acid. These hydantoin derivatives may include any compound that is soluble in the electroless copper plating solution, but are not limited to these. These hydantoin and/or a hydantoin derivative may be used alone or in combination.

The hydantoin and/or the hydantoin derivative useful in the present invention include hydantoin, hydantoic acid, 1-methyl-hydantoin, 5,5-diphenylhydantoin, 5,5-dimethylhydantoin, 1,5,5-trimethylhydantoin and a derivative thereof, but are not limited to these. 5,5-dimethylhydantoin and 5 , 5-diphenylhydantoin are preferred. The hydantoin and/or the hydantoin derivative in the electroless copper plating solution of the present invention can be normally used at a concentration of 1-100g/L and preferably 5-50g/L.

A variety of additives may be incorporated in the electroless copper plating solution of the present invention, as desired. These additives include, for example, a pH adjuster, a layer improver, but are not limited to these.
A pH adjuster keeps pH value of the electroless copper plating solution of the present invention at a preferable value and accelerates a reduction reaction for deposition of copper ions as copper. These pH adjusters include inorganic acids such as sulfuric acid, hydrochloric acid, phosphorous acid and the like, and hydroxides such as sodium hydroxide, potassium hydroxide and the like, but are not limited to these. The pH adjuster may be added in an amount sufficient to adjust the pH of the electroless copper plating solution. The pH of the electroless copper plating solution used in the process for electroless copper plating of the present invention is preferably 10 or more, and more preferably 13 or more.

The layer improver is added for the purpose of improving properties of the copper thin layer produced by the method of the present invention, such as ductility, tensile strength, hardness, internal stress and the like; or for the purpose of refining copper particles to be deposited. These layer improvers include, for example, sulfur-containing compounds such as thio compounds, 2,2'-bipyridyl, 1,1-phenanthroline, potassium ferrocyanide, ethylene oxide type surfactant, polyethylene glycol and the like, but are not limited to these. These additives may be used alone or in combination.
The amount of these additives added to the electroless copper plating solution of the present invention is conveniently set so that each additive exhibits desired efficacy. For example, a concentration of the thio compound is normally 1-100mg/L, preferably 5-10mg/L; a concentration of the bipyridyl compound is normally 1-50mg/L, preferably 5-15mg/L; and a concentration of the surfactant is normally 1-500mg/L, preferably 10-20mg/L.

For resin substrates of the present invention, any substrates having suitable properties for the application purpose, for example, strength and anti-corrosiveness, can be used; and they can be of any form without any specific limitation. The resin substrates that can be used in the present invention are not particularly limited to resin moldings but may be a composite including reinforcing materials, such as glass fibers interposed between the resins; or a composite having a resin layer on the substrate of various materials, such as a ceramic, glass, metals and the like.
Any resin can be used as resin substrates, for example, polyolefin resins, for example, polyethylene resins such as a high-density polyethylene;, a mid-density polyethylene; a branched low-density polyethylene; a linear low-density polyethylene; super high molecular weight polyethylene; a polypropylene resin; a polybutadien resin; a polybutene resin; a polybutylene resin; a polystyrene resin and the like. Also there can be used halogen-containing resins such as polyvinyl chloride; polyvinylidene chloride; a polyvinylidene chloride-vinyl chloride copolymer resin; chlorinated polyethylene; chlorinated polypropylene; tetrafluoro ethylene and the like. In addition, there can be used an AS resin; an ABS resin; a MBS resin; a polyvinyl alcohol resin; polyacrylate resins such as polymethyl acrylate; polymethacrylate resins such as polymethyl methacrylate; a methyl methacrylate-styrene copolymer resin; a maleic anhydride-styrene copolymer resin; a polyvinyl acetate resin; cellulose resins such as a propinoic acid cellulose resin, a cellulose acetate resin; an epoxy resin; a polyimide resin; polyamide resins such as nylon; a polyamide-imide resin; polyallylate resin; polyether-imide resin, plyether-etherketone resin; a polyethylene oxide resin; various polyester resins such as a PET resin; a polycarbonate resin; a polysulfon resin; a polyvinyl ether resin; a polyvinyl butyral; polyphenylene ether resins such as polyphenylene oxide; a polyphenylene sulfide resin; a polybutylene terephthalate resin; a polymethyl pentene resin; a polyacetal resin; a vinyl chloride-vinyl acetate copolymer resin; ethylene-vinyl acetate copolymer; ethylene-vinyl chloride copolymer; and thermoplastic resins such as copolymers thereof as well as blends thereof; thermosetting resins such as an epoxy resin; a xylene resin; a guanamine resin; a diallyl phthalate resin; a vinyl ester resin; a phenol resin; an unsaturated polyester resin; furan resin; a polyimide resin; a polyurethane resin; a maleic acid resin; a melamine resin; a urea resin and the like, and blends thereof, but are not limited to these. Preferable resins include an epoxy resin, a polyimide resin, a vinyl resin, a phenol resin, a nylon resin, a polyphenylene ether resin, a polypropylene resin, a fluorine type resin and a ABS resin, more preferable resins include an epoxy resin, a polyimide resin, a polyphenylene ether resin, a fluorine type resin and a ABS resin, even more preferably an epoxy resin and a polyimide resin. Resin substrates may be comprised of single resin or plural resins. Composites having coated or laminated resin on the other substrate may be employed.

As a palladium or palladium-tin catalyst used in the present invention, a conventional commercially available palladium or palladium-tin catalyst may be employed. Catalysts to be used are those in the form of liquid catalyst in which a palladium or palladium tin catalyst exists in the medium as a colloid. For example, water diluted solution of Crimson Activator-5300, a palladium-tin catalyst, available from Shipley Company, ConductronDP-H activator conc., a palladium-tin catalyst, available from LeaRonal Japan Inc. can be used, but are not limited to these. When the palladium-tin catalyst is used, a ratio of palladium to tin is, palladium: tin=1:1 - 1:100, more preferably 1:1-1:10.

In the process for electroless copper plating of the present invention, firstly the palladium or palladium-tin catalyst is deposited on a resin substrate. As the method for depositing a catalyst, any method capable of depositing a catalyst on a resin substrate can be used, for example, immersing the resin substrate in the catalyst solution, or spraying the catalyst solution on the resin substrate, but are not limited to these. In addition, before contacting a catalyst with a resin substrate, the resin substrate, may be subjected to a conditioning treatment and etching treatment, for example, by immersing the resin substrate in the catalyst solution; or by spraying the catalyst solution to the resin substrate, in order to make a palladium or palladium-tin catalyst susceptible to depositing on the resin substrate, if desired.

A concentration of the catalyst in the catalyst solution used in the present invention is 30 mg/L-500mg/L and preferably 70mg/L-200mg/L as a palladium concentration. When the concentration of palladium is too low, sufficient deposition of copper from the copper solution including a reducing agent cannot be obtained. When the concentration of palladium is too high, adsorption of the palladium catalyst becomes excessive, therefore, the adhesion property of the catalyst is reduced and costs are increased.
As mentioned above, the depositing treatment of the catalyst on the resin substrate is performed by immersing the resin substrate in the catalyst solution or by spraying the catalyst solution on the resin substrate. In the case of vertical treatment, a treatment time required for deposition is normally 3 to 10 minutes, and preferably 5 to 8 minutes; and the treatment temperature for the depositing is normally 25 to 50°C and preferably 35 to 45°C. In the case of horizontal treatment, a treatment time required for deposition is normally 15 seconds to 3 minutes, and preferably 30 seconds to 2 minutes; and a treatment temperature for the depositing is normally 25 to 50°C and preferably 35 to 45°C.

Next, in the process for electroless copper plating of the present invention, the resin substrate obtained by the aforementioned treatment, having a catalyst on the surface thereof, is treated with the electroless copper plating solution of the present invention without conducting any accelerating treatment, which treatment is performed in the conventional art. In a conventional electroless copper plating process using formaldehyde, tin is removed from the palladium-tin catalyst during the acceleration step that is conducted after the catalyst has been imparted. This is due to the fact that palladium, that has a high catalyst activity to formaldehyde, is not exposed before the catalyst is subjected to the accelerating treatment. Therefore, it takes an extremely long time to induce the reaction of the electroless copper plating, as compared to a case where the catalyst has been subjected to the accelerating treatment. When a catalyst that has not been subjected to the accelerating treatment is used, impurities derived from the decomposed material of catalyst are incorporated into the liquid solution, making the electroless copper plating solution unstable, and giving rise to a danger of decomposition.

The passage "without conducting the accelerating treatment of a catalyst" in the present invention means that no treatment for enhancing catalytic activities is performed; which would otherwise be performed as an independent step between the step of depositing the non-activated catalyst on the resin and the step of subsequent treatment with the electroless copper plating solution. When said electroless copper plating solution contains a reducing agent having a high reactivity, during treatment with the electroless copper plating solution of the present invention, the catalyst is activated in the electroless copper plating solution and, simultaneously, the electroless copper plating reaction is carried out. In this instance, activity of the catalyst is enhanced. However, such activation is not performed in a single independent step. Therefore, even where enhancement of activity of the catalyst is achieved by treatment with an electroless copper plating solution, such enhancement is included within the scope of the description "without conducting the accelerating treatment of a catalyst" in the present specification.

The electroless copper plating solution forms a copper thin layer on the resin substrate and produces the copper-resin composite material, because the electroless copper plating solution of the present invention contains copper ions and a reducing agent. In the electroless copper plating process of the present invention, palladium or palladium-tin is present as a metal in the copper thin layer of said copper-resin composite material, because the resin substrate is treated with the electroless copper plating solution after the catalyst has been deposited on the resin substrate.
In the present invention, when the substrate having the catalyst deposited thereon is contacted with the electroless copper plating solution of the present invention, copper rapidly begins to deposit, and the reaction is completed when the entire surface of the catalyst is coated with copper. Although the thickness of the copper thin layer at the time of completion of the deposition reaction is adjustable by altering the various conditions, it is normally 0.01-0.2µm, and preferably 0.03-0.1. In any case, it is thinner than 0.2-0.5µm, which is the common thickness of the copper thin layer obtained by the process comprising an accelerating treatment step carried out with an electroless copper plating step, the electroless copper plating solution containing formaldehyde and employing the same catalyst and resin substrate.

The deposition rate of the copper layer in the present invention is defined as the thickness of the copper layer at 1 minute after contact of the electroless copper plating solution of the present invention with the substrate. Provided that, when the deposition of the copper layer is completed within one minute, the time of measurement is appropriately set so as to be a time taken for completion of deposition of the copper layer.
When the electroless copper plating solution containing formaldehyde is used, since deposited copper functions self-catalytically, completion of the deposition of the copper layer as in the present invention does not occur. Even in this situation, the deposition rate of the copper layer is defined as the thickness of the copper layer at one minute after contact of the electroless copper plating solution with the resin. When deposition of copper is not observed in a period of one minute after contact of the electroless copper plating solution with the substrate, the deposition rate is expressed as 0 µm/minute.
In the method for the electroless copper plating of the present invention, the deposition rate is preferably 0.02 µm/minute or more, and more preferably 0.05 µm/minute or more.

Treatment with the electroless copper plating solution of the present invention is performed by immersing the resin substrate in the electroless copper plating solution, or by spraying the electroless copper plating solution on the resin substrate. In vertical treatment, a bath solution treatment time is normally 1-5 minutes, preferably 1-2 minute; and a temperature during treatment with the bath solution is normally 30-70°C, preferably50-60°C. In horizontal treatment, a bath solution treatment time is normally 15 seconds to 2 minutes, preferably 30 seconds to 1 minute; and a temperature during treatment with the bath solution is normally 30-70°C, and preferably 50-60°C. In the preferred embodiment of the present invention, as compared with the conventional art wherein electroless copper plating is performed using an electroless copper solution containing formaldehyde and employing the same catalyst and resin substrate, a deposition time is shortened and a treatment time required for the entire system is also shortened.

The copper-resin composite material obtained by the process for electroless copper plating of the present invention may be applied to the electroless copper plating treatment to form a further copper layer on the copper thin layer of the composite material. As the electroless copper plating method aforementioned, any electroless copper plating process that is known in the art, such copper sulfate plating copper cyanide plating, and copper pyrophosphate plating can be used. Preferably, copper sulfate plating is employed.

### Examples

In the following examples, each process of each Example and Comparative Example was practiced under normal conditions using a commercially available chemical agent commonly used in such a process, unless specified otherwise.
The treatment time using the electroless copper plating solution in the following process is the period of time required until the deposition of copper is almost completed. The deposition rate of the copper layer was calculated by measuring the thickness of the deposited copper-plated layer during deposition, until one minute after the contact of the electroless copper plating solution of the present invention with the substrate. In the case that, when the deposition is completed within one minute, the deposition rate to the appropriate point before the deposition is almost completed was measured.
The method used for measuring the deposition rate of the copper layer is as follows: 1) measure the weight of a sufficiently dried glass-epoxy substrate with a precision balance; 2) perform electroless copper plating on said substrate; 3) determine the increase in the balance of the weight by measuring the weight of the treated substrate after drying; 4) calculate the deposition thickness from the increase of the weight and the surface area of the substrate.

### Examples 1-8 and Comparative Example 1

Comparison of the copper―resin composite material obtained by the process for electroless copper plating of the present invention and the process electro plating copper with those obtained by the conventional process of electroless copper plating
A copper-clad four-layer laminate having a sheet thickness of 1.6mm (manufactured by Hitachi Chemical Co.,Ltd.) comprising glass fibers and a bisphenol A type epoxy resin (FR-4) was used as a resin substrate. Vertical treatment was applied to Examples 1-6,10 and 11, and the Comparative Example 1. Horizontal treatment was applied to Examples 7,8 and Example 9. For Example 8, the change in thickness of the deposited copper layer over time was measured.

### Example 1

### [Table 1]

**Table 1**

| Step | Treatment temperature | Treatment time |
|---|---|---|
| Conditioning | 60°C | 5minutes |
| Etching | 25°C | 1minutes |
| Pd-Sn catalyst impartment | 43°C | 5minutes |
| Formaldehyde-free electroless copper plating solution* | 60°C | 5minutes |
| Electrolytic copper plating | 25°C | 40minutes |

| | | |
|---|---|---|
| *: Formaldehyde-free electroless copper plating solution | | |

| | |
|---|---|
| Copper sulfate pentahydrate | 15g/L |
| EDTA | 45g/L |
| Sodium boron hydride | 1g/L |
| 2,2'-bipyridyl | 10mg/L |
| pH | 12.5 |

When treated with the process described above, the time required from the initiation of treatment to completion of electroless copper plating treatment was 16 minutes; and the time required for electroless copper plating treatment was 5 minutes. A copper layer having a thickness of 0.05 micrometer was obtained. The deposition rate of the copper layer was 0.01micrometer/minute. The observation of 100 holes having a diameter of 0.3mm revealed that the electro plated copper layer had 26% void occurrence ratio where the copper layer was not formed. The prepared electroless copper plating solution was decomposed immediately after the test.

### Example 2

### [Table 2]

**Table 2**

| Step | Treatment temperature | Treatment time |
|---|---|---|
| Conditioning | 60°C | 5minutes |
| Etching | 25°C | 1minutes |
| Pd-Sn catalyst impartment | 43°C | 5minutes |
| Formaldehyde-free electroless copper plating solution* | 60°C | 5minutes |
| Electrolytic copper plating | 25°C | 40minutes |

| | | |
|---|---|---|
| *: Formaldehyde-free electroless copper plating solution | | |

| | |
|---|---|
| Copper sulfate pentahydrate | 15g/L |
| EDTA | 45g/L |
| Sodium boron hydride | 1g/L |
| 2,2'-bipyridyl | 10mg/L |
| Thallium sulfate | 14mg/L |
| pH | 12.5 |

When treated by the process described above, the time required from initiation of treatment to completion of electroless copper plating treatment was 16 minutes; and the time required for electroless copper plating treatment was 5 minutes. A copper layer having a thickness of 0.05 micrometer was obtained. The deposition rate of the copper layer was 0.01micrometer/minute.
In performance evaluation, the observation of 100 holes having a diameter of 0.3mm of the copper-clad four-layer laminate revealed that the electro plated copper layer had 16% void occurrence ratio. However, the decomposition of the electroless copper plating solution was not observed.
As compared with Example 1 and Example 2, although treatment times for electroless copper plating were the same, a void occurrence ratio was lower in Example 2 and coating properties were enhanced. From this result, it is apparent that the deposition properties of the copper layer in Example 2 were improved. Further, it was demonstrated that by adding thallium to the electrolytic copper plating solution, decomposition of the electroless copper solution was suppressed.

### Example 3

### [Table 3]

**Table 3**

| Step | Treatment temperature | Treatment time |
|---|---|---|
| Conditioning | 60°C | 5minutes |
| Etching | 25°C | 1minutes |
| Pd-Sn catalyst impartment | 43°C | 5minutes |
| Formaldehyde-free electroless copper plating solution* | 60°C | 2minutes |
| Electrolytic copper plating | 25°C | 40minutes |

| | | |
|---|---|---|
| *: Formaldehyde-free electroless copper plating solution | | |

| | |
|---|---|
| Copper sulfate pentahydrate | 15g/L |
| Dimethylhydantoin | 30g/L |
| Sodium boron hydride | 0.5g/L |
| 2,2'-bipyridyl | 10mg/L |
| Thallium sulfate | 14mg/L |
| pH | 13.0 |

When treated by the process described above, the time required from
initiation of treatment to completion of electroless copper plating treatment was 13 minutes; and the time required for electroless copper plating treatment was 2 minutes. A copper layer having a thickness of 0.08 micrometer was obtained. The deposition rate of the copper layer was 0.04micrometer/minute.
In the performance test, even in the case that a heat resistance test including 100 cycles (260°C oil/10 seconds, 25°C methanol/10 seconds) was conducted, there was no exfoliation of the bonding between the inner copper foil layer and the copper sulfate plated layer. The observation of 100 holes having a diameter of 0.3 mm revealed that the electro plated copper layer had no voids and was indicative of a good result. Further, no decomposition of the electroless copper plating solution was observed.

### Example 4

### [Table 4]

**Table4**

| Step | Treatment temperature | Treatment time |
|---|---|---|
| Conditioning | 60°C | 5minutes |
| Etching | 25°C | 1minutes |
| Pd-Sn catalyst impartment | 43°C | 5minutes |
| Formaldehyde-free electroless copper plating solution* | 60°C | 2minutes |
| Electrolytic copper plating | 25°C | 40minutes |

| | | |
|---|---|---|
| *: Formaldehyde-free electroless copper plating solution | | |

| | |
|---|---|
| Copper sulfate pentahydrate | 15g/L |
| Dimethylhydantoin | 30g/L |
| Sodium boron hydride | 0.5g/L |
| 1,10-phenanthroline | 10mg/L |
| Thallium sulfate | 14mg/L |
| pH | 13.0 |

When treated by the process described above, the time required from the initiation of treatment to completion of electroless copper plating treatment was 13 minutes; and the time required for electroless copper plating treatment was 2 minutes. A copper layer having a thickness of 0.08 micrometer was obtained. The deposition rate of the copper layer was 0.04micrometer/minute.
In the performance test, even in the case that a heat resistance test including 100 cycles (260°C oil/10 seconds, 25°C methanol/10 seconds) was conducted, there was no exfoliation of the bonding between the inner copper foil layer and the copper sulfate plated layer. The observation of 100 holes having a diameter of 0.3 mm revealed that the electro plated copper layer had no voids and was indicative of a good result. Further, no decomposition of the electroless copper plating solution was observed.
From the results of Examples 2 and 3, it was found that the effect of the present invention was obtained notwithstanding the types of the layer improver used.

### Example 5

### [Table 5]

**Table 5**

| Step | Treatment temperature | Treatment time |
|---|---|---|
| Conditioning | 60°C | 5minutes |
| Etching | 25°C | 1minutes |
| Pd-Sn catalyst impartment | 43°C | 5minutes |
| Formaldehyde-free electroless copper plating solution* | 60°C | 1minutes |
| Electrolytic copper plating | 25°C | 40minutes |

| | | |
|---|---|---|
| *: Formaldehyde-free electroless copper plating solution | | |

| | |
|---|---|
| Copper sulfate pentahydrate | 4g/L |
| Dimethylhydantoin | 30g/L |
| Sodium boron hydride | 0.5g/L |
| 2,2'-bipyridyl | 10mg/L |
| Cerium acetate | 15mg/L |
| Potassium iodide | 10mg/L |
| pH | 12.5 |

When treated by the process described above, the time required from the initiation of treatment to the completion of electroless copper plating treatment was 12 minutes; and the time required for electroless copper plating treatment was 1 minute. A copper layer having a thickness of 0.06 micrometer was obtained. The deposition rate of the copper layer was 0.06micrometer/minute.
In the performance test, even in the case that a heat resistance test including 100 cycles (260°C oil/10 seconds, 25°C methanol/10 seconds) was conducted, there was no exfoliation of the bonding between the inner copper foil layer and the copper sulfate plated layer. The observation of 100 holes having a diameter of 0.3 mm revealed that the electro plated copper layer had no voids and was indicative of a good result. Further, no decomposition of the electroless copper plating solution was observed.

### Example 6

### [Table6]

**Table 6**

| Step | Treatment temperature | Treatment time |
|---|---|---|
| Conditioning | 60°C | 5minutes |
| Etching | 25°C | 1minutes |
| Pd-Sn catalyst impartment | 43°C | 5minutes |
| Formaldehyde-free electroless copper plating solution* | 60°C | 1minutes |
| Electrolytic copper plating | 25°C | 40minutes |

| | | |
|---|---|---|
| *: Formaldehvde-free electroless copper plating solution | | |

| | |
|---|---|
| Copper sulfate pentahydrate | 4g/L |
| Dimethylhydantoin | 30g/L |
| Sodium boron hydride | 0.5g/L |
| Potassium ferrocyanid | 10mg/L |
| Cerium acetate | 15mg/L |
| Potassium iodide | 10mg/L |
| pH | 12.5 |

When treated by the process described above, the time required from the initiation of treatment to the completion of electroless copper plating treatment was 12 minutes; and the time required for electroless copper plating treatment was 1 minute. A copper layer having a thickness of 0.06 micrometer was obtained. The deposition rate of the copper layer was 0.06micrometer/minute.
In the performance test, even in the case that a heat resistance test including 100 cycles (260°C oil/10 seconds, 25°C methanol/10 seconds) was conducted, there was no exfoliation of the bonding between the inner copper foil layer and the copper sulfate plated layer. The observation of 100 holes having a diameter of 0.3 mm revealed that the electro plated copper layer had no voids and was indicative of a good result. Further, no decomposition of the electroless copper plating solution was observed.
From the results of examples 5 and 6, it was found that the effect of the present invention was obtained notwithstanding the types of the layer improver used.

In comparison with examples 2 through 6, the completion time of electroless copper plating treatment was 5 minutes in example 2, 2 minutes in examples 3 and 4, and 1 minute in Examples 5 and 6. Dimethylhydantoin was used in examples 3 and 4, and dimethylhydantoin and potassium iodide were used in Examples 5 and 6. From these, it was found that a hydantoin compound and iodine element enhances the deposition rate of copper in the process of electroless copper plating of the present invention.

### Example 7

### [Table 7]

**Table 7**

| Step | Treatment temperature | Treatment time |
|---|---|---|
| Conditioning | 60°C | 15seconds |
| Etching | 25°C | 15seconds |
| Pd-Sn catalyst impartment | 43°C | 30seconds |
| Formaldehyde-free electroless copper plating solution* | 60°C | 30seconds |
| Electrolytic copper plating | 25°C | 40minutes |

| | | |
|---|---|---|
| *: Formaldehyde-free electroless copper plating solution | | |

| | |
|---|---|
| Copper sulfate pentahydrate | 4g/L |
| Dimethylhydantoin | 30g/L |
| Sodium boron hydride | 0.5g/L |
| Triethanolamine | 4g/L |
| 2,2'-bipyridyl | 10mg/L |
| Cerium acetate | 15mg/L |
| 8-hydroxy-7-iodo-5-quinolinesulfonic acid | 10mg/L |
| pH | 13.0 |

When treated by the process described above, the time required from initiation of treatment to completion of electroless copper plating treatment was 1 minute and 30 seconds; and the time required for electroless copper plating treatment was 30 seconds. The copper layer having a thickness of 0.05 micrometer was obtained. The deposition rate of the copper layer was 0.1micrometer/minute.
In the performance test, even in the case that a heat resistance test including 100 cycles (260°C oil/10 seconds, 25°C methanol/10 seconds) was conducted, there was no exfoliation of the bonding between the inner copper foil layer and the copper sulfate plated layer. The observation of 100 holes having a diameter of 0.3 mm revealed that the electro plated copper layer had no voids and was indicative of a good result. Further, no decomposition of the electroless copper plating solution was observed.
From the result of Example 7, it is found that addition of an iodine
element enhances the deposition rate of copper, even if iodine is present in the form of an iodine compound.

### Example 8

### [Table 8]

**Table 8**

| Step | Treatment temperature | Treatment time |
|---|---|---|
| Conditioning | 60°C | 15seconds |
| Etching | 25°C | 15seconds |
| Pd-Sn catalyst impartment | 43°C | 30seconds |
| Formaldehyde-free electroless copper plating solution* | 60°C | 30seconds |
| Electrolytic copper plating | 25°C | 40minutes |

| | | |
|---|---|---|
| *: Formaldehyde-free electroless copper plating solution | | |

| | |
|---|---|
| Copper sulfate pentahydrate | 4g/L |
| Dimethylhydantoin | 30g/L |
| Sodium boron hydride | 0.5g/L |
| Triethanolamine | 4g/L |
| Sodium sulfate | 10mg/L |
| Cerium acetate | 15mg/L |
| 8-hydroxy-7-iodo-5-quinolinesulfonic acid | 10mg/L |
| pH | 13.0 |

When treated by the process described above, the time required from the initiation of treatment to the completion of electroless copper plating treatment was 1 minute and 30 seconds; and the time required for electroless copper plating treatment was 30 seconds. A copper layer having a thickness of 0.05 micrometer was obtained. The deposition rate of the copper layer was 0.1micrometer/minute.
In the performance test, even in the case that a heat resistance test including 100 cycles (260°C oil/10 seconds, 25°C methanol/10 seconds) was conducted, there was no exfoliation of the bonding between the inner copper foil layer and the copper sulfate plated layer. The observation of 100 holes having a diameter of 0.3 mm revealed that the electro plated copper layer had no voids and was indicative of a good result. Further, no decomposition of the electroless copper plating solution was observed
From the result of Example 8, it is found that the effect of the present invention was obtained, even if a sulfide is used together with a cerium compound.

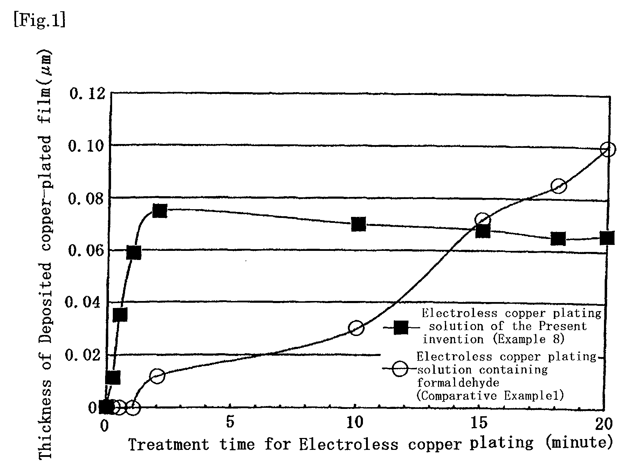

A change in the thickness of the deposited copper layer by vertical treatment over time was measured using the electroless copper plating solution having a composition of Example 8. The experiment was conducted under the following conditions: conditioning step, 60°C, 5 minutes; etching step, 25°C, 1 minute; Pd-Sn catalyst imparting step, 43°C, 5 minutes. The treatment step with a F free electroless copper plating solution was conducted for 20 minutes at 60°C, and the layer thickness of deposited copper was measured over time. The result is shown in Fig.1.

### Comparative Example 1

### [Table 9]

**Table 9**

| Step | Treatment temperature | Treatment time |
|---|---|---|
| Conditioning | 60°C | 5minutes |
| Etching | 25°C | 1minutes |
| Pd-Sn catalyst impartment | 43°C | 5minutes |
| Electroless copper plating solution* | 60°C | 1minutes |
| Electrolytic copper plating | 25°C | 40minutes |

| | | |
|---|---|---|
| *: Electroless copper plating solution | | |

| | |
|---|---|
| Copper sulfate pentahydrate | 4g/L |
| EDTA | 45g/L |
| Formaldehyde | 20g/L |
| 2,2'-bipyridyl | 10mg/L |
| pH | 12.5 |

The time required for the electroless copper plating treatment in Comparative Example 1 was 1 minute, and was the same as for examples 5 and 6. However, deposition of copper was not observed. That is, with respect to the coating properties of the electric copper- plated layer, the observation of 100 holes having a diameter of 0.3 mm revealed that its coating properties have a 100% void occurrence ratio, and deposition of copper with the electroless copper plating solution was not identified. Decomposition of the electroless copper plating solution was not observed.
In Comparative Example 1, the electroless copper plating treatment was further continued in order to deposit a copper layer having a layer thickness of a degree usable for electro copper plating treatment. And the layer thickness of deposited copper was measured over time. It took 20 minutes to deposit a copper layer of 0.1micrometer. The change in the thickness of a deposited copper layer with the lapse of time is shown in Fig.1.

As is apparent from Fig1, deposition of copper with the conventional electroless copper plating solutions that contain formaldehyde was not observed immediately after treatment with the electroless copper plating solution. On the other hand, in Example 8, that is the electroless copper plating solution of the present invention, deposition of copper was observed immediately after the electroless copper plating treatment. The layer thickness increased almost linearly until 1 minute after the start of the treatment, and the deposition rate of the copper layer was 0.06micrometer/minute. The deposition reaction was almost completed within 2 minutes following the commencement of treatment
The layer thickness at that time was 0.075micrometer.
As mentioned, the deposition of copper with the electroless copper plating solution containing formaldehyde was greatly delayed when the accelerating treatment of a catalyst was not conducted. However, as is apparent from the results shown in Examples 1 through 8, it was found that the electroless copper plating solution of the present invention could greatly enhance the deposition rate of copper even if a catalyst is not subjected to an accelerating treatment. Further, as shown in Examples 1 through 8, the composite material obtained by performing electrolytic copper plating on the layer formed with the process of electroless copper plating of the present invention has excellent heat resistance and adhesion properties. In addition, the void occurrence ratio of said composite material was lowered. Therefore, it was demonstrated that the process for electroless copper plating of the present invention is capable of forming a copper layer suitable for electrolytic copper plating in a short time.

### Example 9

### [Table 10]

**Table 10**

| Step | Treatment temperature | Treatment time |
|---|---|---|
| Conditioning | 60°C | 15seconds |
| Etching | 25°C | 15seconds |
| Pd-Sn catalyst impartment | 43°C | 30seconds |
| Formaldehyde-free electroless copper plating solution* | 60°C | 30seconds |
| Electrolytic copper plating | 25°C | 40minutes |

| | | |
|---|---|---|
| *: Formaldehyde-free electroless copper plating solution | | |

| | |
|---|---|
| Copper sulfate pentahydrate | 4g/L |
| Dimethylhydantoin | 30g/L |
| Sodium boron hydride | 0.5g/L |
| Triethanolamine | 4g/L |
| Sodium sulfate | 10mg/L |
| Cerium acetate | 15mg/L |
| pH | 13.0 |

When treated by the process described above, the time required from the initiation of treatment to the completion of electroless copper plating treatment was 1 minute and 30 seconds; and the time required for electroless copper plating treatment was 30 seconds. A copper layer having a thickness of 0.03 micrometer was obtained. The deposition rate of the copper layer was 0.06micrometer/minute.
In the performance test, even in the case that a heat resistance test including 100 cycles (260°C oil/10 seconds, 25°C methanol/10 seconds) was conducted, there was no exfoliation of the bonding between the inner copper foil layer and the copper sulfate plated layer. The observation of 100 holes having a diameter of 0.3 mm revealed that the electro plated copper layer had no voids and was indicative of a good result. Further, no decomposition of the electroless copper plating solution was observed.
As compared with the results between Example 9 and Example 8, the deposition rate for Example 9, wherein an iodine element was not contained, was 0.06micrometer/minute, whereas the deposition rate for Example 8, wherein iodine element was contained, was 0.10micrometer/minute. Thus, it is recognized that the addition of iodine enhanced the deposition rate.

### Example 10

### [Table 11]

**Table 11**

| Step | Treatment temperature | Treatment time |
|---|---|---|
| Conditioning | 60°C | 5 minutes |
| Etching | 25°C | 1 minutes |
| Pd-Sn catalyst impartment | 43°C | 5 minutes |
| Formaldehyde-free electroless copper plating solution* | 60°C | 1 minutes |
| Electrolytic copper plating | 25°C | 40minutes |

| | | |
|---|---|---|
| *: Formaldehyde-free electroless copper plating solution | | |

| | |
|---|---|
| Copper sulfate pentahydrate | 4g/L |
| Sodium boron hydride | 0.5g/L |
| Triethanolamine | 4g/L |
| Thallium chloride | 15mg/L |
| Sodium iodide | 10mg/L |
| pH | 13.0 |

When treated by the process described above, the time required from the initiation of treatment to the completion of electroless copper plating treatment was 12 minutes, and the time required for electroless copper plating treatment was 1 minute. A copper layer having a thickness of 0.06 micrometer was obtained. The deposition rate of the copper layer was 0.06micrometer/minute.
In the performance test, even in the case that a heat resistance test including 100 cycles (260°C oil/10 seconds, 25°C methanol/10 seconds) was conducted, there was no exfoliation of the bonding between the inner copper foil layer and the copper sulfate plated layer. The observation of 100 holes having a diameter of 0.3 mm revealed that the electro plated copper layer had no voids and was indicative of a good result. Further, no decomposition of the electroless copper plating solution was observed.
As compared with the results between Example 10 and Example 2, the deposition rate for Example 2, wherein an iodine element is not contained, was 0.01micrometer/minute, whereas the deposition rate for Example 10, wherein iodine element is contained, was 0.06micrometer/minute. Thus, it is recognized that addition of iodine greatly enhanced the deposition rate.

### [Table 12]

**Table 12**

| Step | Treatment temperature | Treatment time |
|---|---|---|
| Conditioning | 60°C | 5 minutes |
| Etching | 25°C | 1 minutes |
| Pd-Sn catalyst impartment | 43°C | 5 minutes |
| Formaldehyde-free electroless copper plating solution* | 60°C | 1 minutes |
| Electrolytic copper plating | 25°C | 40minutes |

| | | |
|---|---|---|
| *: Formaldehyde-free electroless copper plating solution | | |

| | |
|---|---|
| Copper sulfate pentahydrate | 4g/L |
| Sodium boron hydride | 0.5g/L |
| Triethanolamine | 4g/L |
| 8-hydroxy-7-iodo-5-quinolinesulfonic acid | 10mg/L |
| pH | 13.0 |

When treated by the process described above, the time required from initiation of treatment to the completion of electroless copper plating treatment was 12 minutes, and the time required for electroless copper plating treatment was 1 minute. A copper layer having a thickness of 0.06 micrometer was obtained. The deposition rate of the copper layer was 0.06micrometer/minute.
In performance evaluation, even when a 100 cycle heat resistance test was applied test (260°C oil/10 seconds, 25°C methanol/10 seconds) were conducted, there was no exfoliation of the bonding between the inner copper foil layer and the copper sulfate plated layer. The observation of 100 holes having a diameter of 0.3mm revealed that the electro plated copper layer had no void and showed a good result. And, decomposition of the electroless copper plating solution was not observed.
As compared with the results seen between Example 11 and Example 1, the deposition rate for example 1, wherein iodine element is not contained, was 0.01micrometer/minute, whereas the deposition rate for Example 11, wherein an iodine element is contained, was 0.06micrometer/minute. Thus, it is recognized that the addition of iodine extremely enhanced the deposition rate. Simultaneously, the decomposition of the electroless copper plating solution in Example 1 was observed. However, the decomposition was not observed in Example 11.
From these, it was found that iodine element simultaneously enhanced the deposition rate as well as the stability of an electroless copper plating solution.

The appearance of the deposited copper layers in Examples 1 through 11 was observed by visual inspection. The appearance for Examples 5 to 8, 10 and 11, in which each electroless copper plating solution contains an iodine element, was glossy with a metallic color tone. On the other hand, the appearance for Examples 2 to 4 and Example 9, in which each electroless copper plating solution contains no iodine element, did not have a glossy appearance or metallic color tone. Thus, it is revealed that addition of an iodine element provides a plated metal copper having a glossy appearance and metallic color tone..
A summary of the results of Examples 1 through 11 and Comparative Example 1 is provided below.

[Table 13]

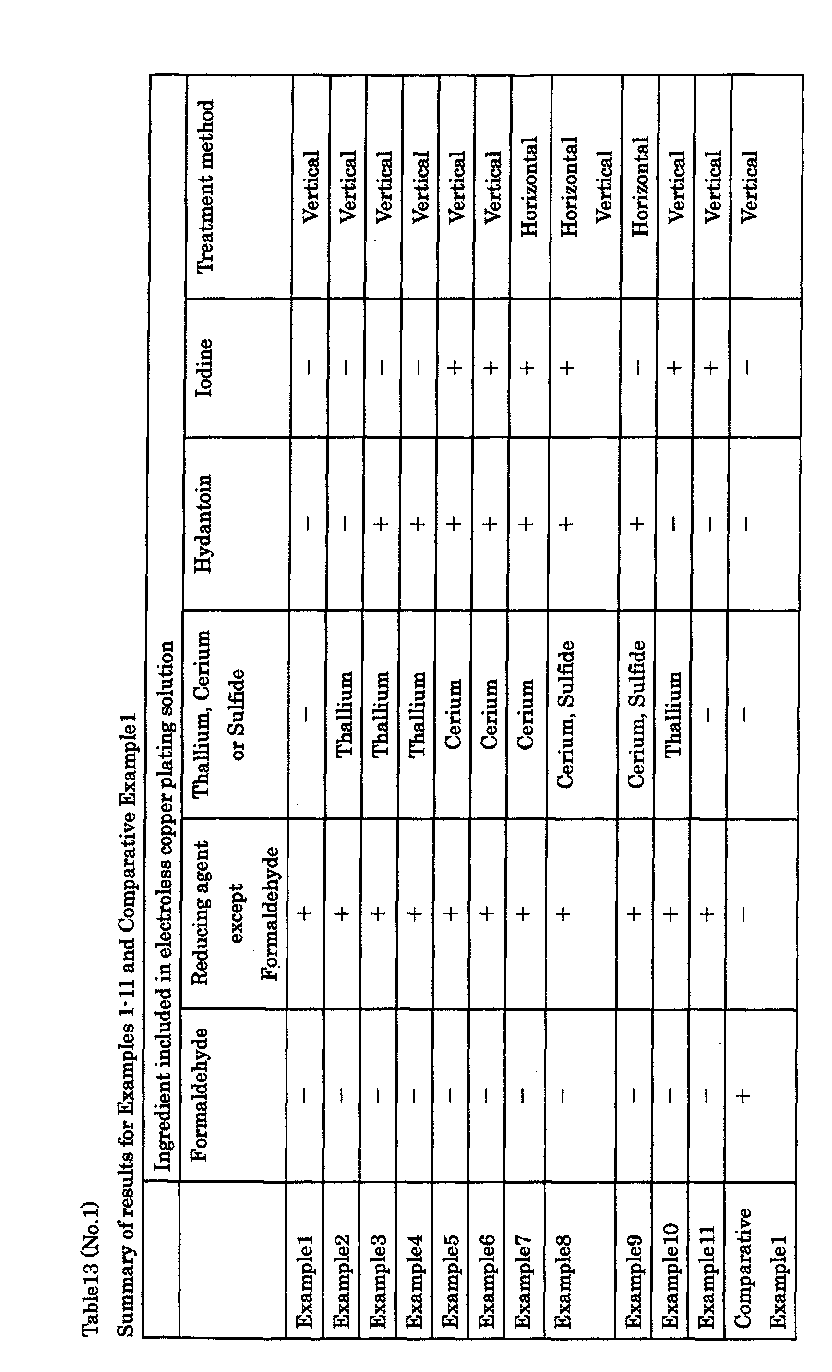

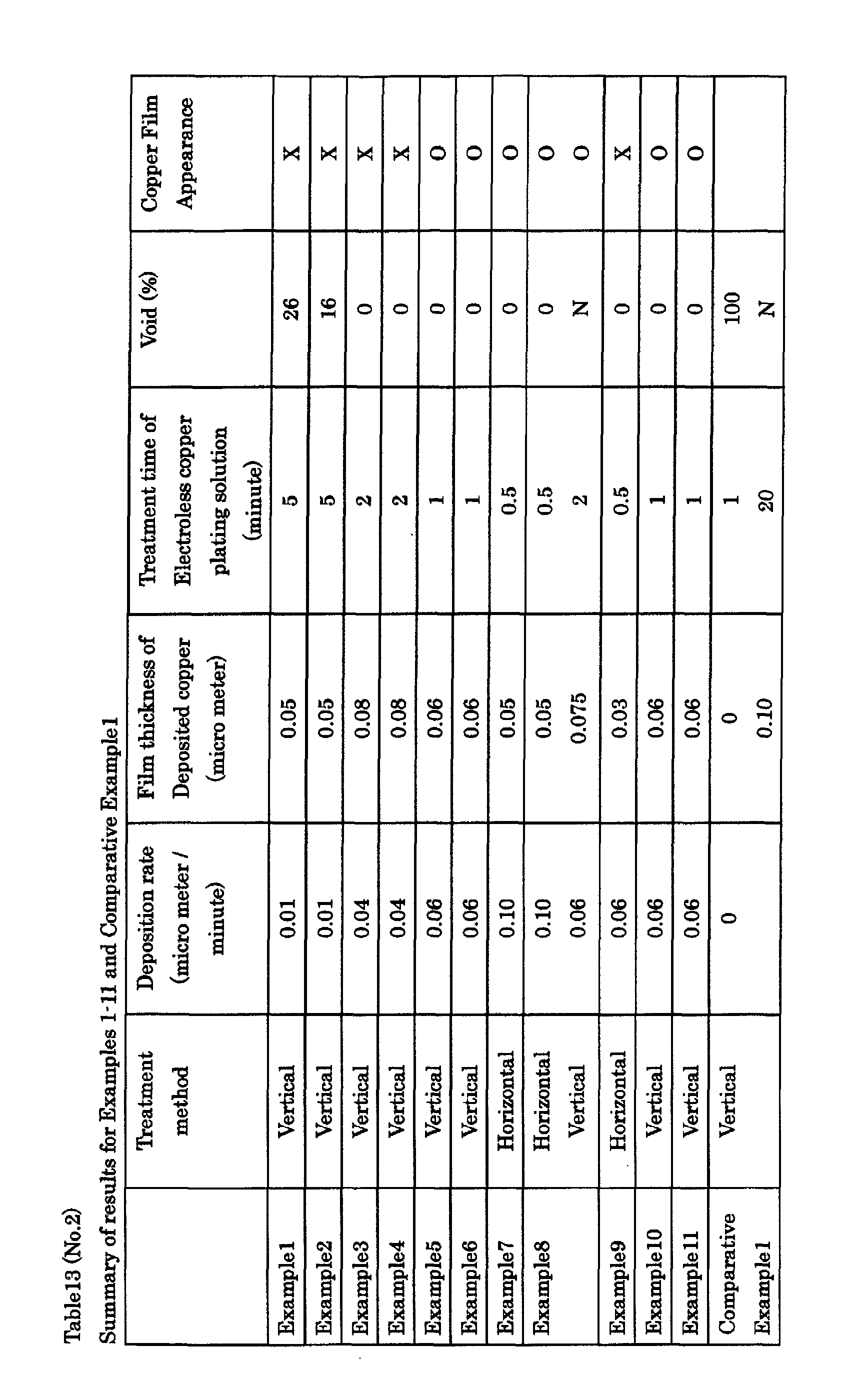

NOTE) In the table above, "-"denote that a corresponding ingredient is excluded and "+" denote that a corresponding ingredient is included. "N" denotes 'not measured'. In the column for color film appearance, "O" denotes that a glossy appearance and metallic copper color tone was attained; and "X" denotes the contrary.

### Example 12 and Comparative Example 2

### Bath stabilization by a water-soluble thallium compound

Electroless copper plating solutions of Comparative Example 2 and Example 12 shown below were prepared and bath stabilization of them as an electroless copper plating solution was compared.
As a method for evaluating the stabilization of a bath, catalysts containing 350 g/L of palladium and 10 g/L of tin were added to the electroless copper plating solutions of Comparative Example 2 and Example 12. The amount of catalyst added until bath decomposition became evident was compared.

### [Table 14]

**Table 14**

| Comparative Example 2 | | Example 12 | |
|---|---|---|---|
| Bath composition | | Bath composition | |
| Copper sulfate pentahydrate | 15g/L | Copper sulfate pentahydrate | 15g/L |
| Triethanolamine | 5mL/L | Triethanolamine | 5mL/L |
| Sodium boron hydride | 0.5g/L | Sodium boron hydride | 0.5g/L |
| 2,2'-bipyridyl | 10mg/L | 2,2'-bipyridyl Thallium sulfate | 10mg/L 14mg/L |
| | | | |
| pH | 13.0 | pH | 13.0 |
| Temperature | 60°C | Temperature | 60°C |
| Bath stability | Bath was decomposed by addition of 2mL/L Pd solution | Bath stability | Bath was decomposed by addition of 20mL/L Pd solution |

From the result of the above tests, it was found that the electroless copper plating bath solution containing a water soluble thallium compound of the present invention had a bath stability ten times greater than that of the electroless copper plating solution which did not contain a water soluble thallium compound and formaldehyde.

### Example 13 and Comparative Example 3

### Bath stabilization by a water-soluble cerium compound

In a similar manner to Comparative Example 2 and Example 12, the electroless copper plating bath solutions of following Comparative Example 3 and Example 13 were prepared. Subsequently, the bath stability as an electroless copper plating solution was compared.
As a method for evaluating the bath stability, the catalysts containing 200 g/L of palladium and 10 g/L of tin were added to the electroless copper plating solutions of Comparative Example 3 and Example 13. The amount of catalyst added until the bath decomposition was compared.

### [Table 15]

**Table 15**

| Comparative Example 3 | | Example 13 | |
|---|---|---|---|
| Bath composition | | Bath composition | |
| Copper sulfate pentahydrate | 15g/L | Copper sulfate pentahydrate | 15g/L |
| Triethanolamine | 5mL/L | Triethanolamine | 5mL/L |
| Sodium boron hydride | 0.5g/L | Sodium boron hydride | 0.5g/L |
| 2,2'-bipyridyl | 10mg/L | 2,2'-bipyridyl Cerium sulfate | 10mg/L 14mg/L |
| pH | 13.0 | pH | 13.0 |
| Temperature | 60°C | Temperature | 60°C |
| Bath stability | Bath was decomposed by addition of 2mL/L Pd solution | Bath stability | Bath was decomposed by addition of 14mL/L Pd solution |

From the results of above tests, it was found that the electroless copper plating bath solution containing the water soluble cerium compound of the present invention had a 7 times bath stability comparing with the electroless copper plating solution which did not contain a water soluble cerium compound.

### Example 14 and Comparative Example 4

### Bath stabilization by a water-soluble cerium compound

In a similar manner to Comparative Example 3 and Example 13, the electroless copper plating bath solutions of following Comparative Example 4 and Example 14 were prepared. Subsequently, the bath stabilization as an electroless copper plating solution was compared. As a method for evaluating the bath stability, the catalysts containing 200 g/L of palladium and 10 g/L of tin were added to the electroless copper plating solutions of Comparative Example 4 and Example 14. The amount of catalyst added until the bath decomposition was compared.

### [Table 16]

**Table 16**

| Comparative Example4 | | Example 14 | |
|---|---|---|---|
| Bath composition | | Bath composition | |
| Copper sulfate pentahydrate | 15g/L | Copper sulfate pentahydrate | 15g/L |
| Triethanolamine | 5mL/L | Triethanolamine | 5mL/L |
| Sodium boron hydride | 0.5g/L | Sodium boron hydride | 0.5g/L |
| Potassium ferrocyanide | 10mg/L | Potassium ferrocyanide Cerium sulfate | 10mg/L 14mg/L |
| pH | 13.0 | pH | 13.0 |
| Temperature | 60°C | Temperature | 60°C |
| Bath stability | Bath was decomposed by addition of 2mL/L Pd solution | Bath stability | Bath was decomposed by addition of 14mL/L Pd solution |

From the results of these tests, it was found that the electroless copper plating bath solution containing the water soluble cerium compound of the present invention had a bath stability seven times greater than the electroless copper plating not containing a water soluble cerium compound.
It was also found that the effect of suppressing the decomposition of the bath of the present invention could be obtained notwithstanding the type of layer improvers, such as potassium ferrocyanide, 2,2'-bipyridyl.

### [Effect of the Invention]

As explained heretofore, the process for electroless copper plating of the present invention enables the formation of a uniform and dense copper layer on the resin substrate by using the electroless copper plating solution containing a copper ion and a reducing agent, but not containing formaldehyde; and this is the case even where a separate accelerating treatment is not performed. Using the process of the present invention, it is possible to form a uniform and dense copper thin layer on the resin substrate. Use of the process also enhances heat resistance and adhesiveness between the copper plated thin layer obtained by electroless copper plating and the electro plated copper layer obtained by electro copper plating, when electro copper plating has been applied on the electroless plated copper. Further, and significantly, by using a formaldehyde-free process for electroless copper plating dangers associated with the use of the chemical, such as carcinogenosis, teratogenecity and mutagenesis can be avoided.
In addition, the process for electroless copper plating of the present invention enables the formation of a copper thin layer on a resin substrate in a short time, and dramatically enhances the productivity of the copper-resin composite material, even if an accelerating treatment of a catalyst as a separate process is not performed. The reason for the above result is that commencement of a copper deposition reaction in the electroless copper plating treatment is rapid.
Further, the copper thin layer formed by the process for electroless copper plating is more uniform and also denser than the copper thin layer obtained by the conventional process for electroless copper plating, which is known in the art. Accordingly, when applied to electrolytic copper plating, the deposition rate of copper in the electrolytic copper plating is more rapid than that of the copper layer produced by the conventional copper plating that is known in the art. Therefore, it is considered that the process for electroless copper plating of the present invention is suitable for forming a copper thin layer that can be preferably electro copper plated.
Further more, by use of the present invention it is possible to stabilize the electroless copper plating solution by adding any of a water soluble cerium compound, water soluble thallium compound and/or water soluble sulfide to the electroless copper plating solution of the present invention.
The present invention is also able to simultaneously accomplish enhancement of the stability of the electroless copper plating bath as well as enhancement of the deposition rate of copper by adding an iodine element to the electroless copper plating solution. This effect can be accomplished under usual conditions of the process for electroless copper plating. And in this instance, there is an advantage that the deposited copper becomes dense and, consequently, the copper layer has a glossy appearance and metallic copper color tone. In the electroless copper plating field, an appearance of a deposited copper layer is important; and layers having a glossy appearance and metallic tone are preferred. Therefore, with respect to this point, an advantage by adding iodine element is provided.
Further, by using the present invention it is possible to accelerate the deposition rate of copper by adding hydantoin to the electroless copper plating solution.

### [ Brief Description of Drawings]

### [Fig.1]

Fig.1 is a graph indicating the deposition rate of copper when the electroless copper plating solution of examples 8 and comparative example 1 are used; wherein the treatment time of electroless copper plating is plotted in the axis of abscissa, and the layer thickness of deposited copper is plotted in the axis of ordinate.

## Claims

1. A process for electroless copper plating comprising the steps of :
1) depositing a palladium or palladium-tin catalyst on a resin substrate; and
2) treating said resin substrate with a formaldehyde-free electroless copper plating solution, which solution contains a copper ion and a reducing agent and, wherein no catalyst accelerating treatment is carried out after performing said catalyst depositing treatment.

2. The process for electroless copper plating according to claim 1, wherein the electroless copper plating solution further comprises a complexing agent.

3. The process for electroless copper plating according to claim 1 or 2 wherein the reducing agent is selected from a group consisting of sodium boron hydride, potassium boron hydride, dimethylamino borane, trimethylamino borane, hydrazine, derivatives of these compounds and a mixture thereof.

4. The process for electroless copper plating according to any one of claims 1 to 3, wherein the electroless copper plating solution further comprises a water-soluble cerium compound, a water-soluble thallium and/or a water-soluble sulfide.

5. The process for electroless copper plating according to any one of claims 1 to 4, wherein the electroless copper plating solution further comprises iodine and/or a water-soluble iodine compound.

6. The process for electroless copper plating according to any one of claims 1 to 5, wherein the electroless copper plating solution further comprises hydantoin and/or a hydantoin derivative.

7. The process for electroless copper plating according to any one of claims 1 to 6, wherein the deposition rate of copper is 0.05 micrometer/minute or more.

8. An electroless copper plating solution used in the process for electroless copper plating according to any one of claims 1 to 7.

9. A composite material prepared by the process according to any one of claims 1 to 7.

10. The composite material according to claim 9, wherein the thickness of the copper layer deposited on the resin substrate is 0.05 micrometer or more.

11. A process for electro plating copper **characterized by** further applying an electro copper plating on the composite material according to claim 9 or 10.

12. A composite material prepared by the process in accordance with claim 11.
